# DEMANDE DE BREVET EUROPEEN

(11) **EP 4 766 124 A1**
(43) Date de publication de la demande: **24.06.2026**
(21) Numéro de dépôt: 25223924.9
(22) Date de dépôt: 16.12.2025
(51) Int. Cl.: H10N 60/01, H10N 69/00

(54) **JONCTIONS JOSEPHSON ET PROCÈDÈ POUR LES PRODUIRE**

(30) Priorité: 20.12.2024 FR 2414891
(71) Demandeur: COMMISSARIAT À L'ÉNERGIE ATOMIQUE ET AUX ÉNERGIES ALTERNATIVES, 75015 Paris (FR)
(72) Inventeur: CHÊNE, Thibaut, 38054 GRENOBLE Cedex 09 (FR); NEMOUCHI, Fabrice, 38054 GRENOBLE Cedex 09 (FR); LEFLOCH, François, 38054 GRENOBLE Cedex 09 (FR); SEGAUD, Roselyne, 38054 GRENOBLE Cedex 09 (FR); CHEVOLLEAU, Thierry, 38054 GRENOBLE Cedex 09 (FR)
(74) Mandataire: Hautier IP

(57) **Abrégé**

La divulgation concerne un procédé de fabrication d'une jonction Josephson comprenant :
- une fourniture d'un substrat (S),
- une formation d'une première couche supraconductrice (21),
- une formation d'une couche barrière (30a),
- une structuration de la couche barrière (30a) pour former un motif fermé (31) et un motif ouvert (32a),
- une formation d'une deuxième couche supraconductrice (22),
- une gravure de la deuxième couche supraconductrice (22), configurée pour former des vias (221, 222) en s'arrêtant sur la couche barrière (30a) et,
- une gravure de la première couche supraconductrice (21) de part et d'autre du motif fermé (31) et du motif ouvert (32a), configurée pour former des lignes (211, 212).

## Description

### DOMAINE TECHNIQUE

La présente invention concerne le domaine de l'électronique quantique. Elle trouve pour application particulièrement avantageuse la réalisation de jonctions Josephson intégrées dans les niveaux de fin de ligne d'une puce microélectronique.

### ETAT DE LA TECHNIQUE

La jonction Josephson se présente sous forme de deux supraconducteurs séparés par une fine couche isolante, qui agit comme une barrière tunnel entre eux. Dans un métal supraconducteur, le courant circule sans dissipation grâce aux « paires de Cooper », qui sont des paires d'électrons appariées. Lorsque la barrière est suffisamment fine, il est possible de faire traverser les paires de Cooper à travers la barrière par effet tunnel quantique. Une telle barrière laissant passer les électrons entre deux régions supraconductrices s'appelle une jonction Josephson (JJ). Il en résulte un courant non-dissipatif dont l'amplitude dépend de la différence de phase des deux supraconducteurs.

Une grande variété de jonctions JJ existe, selon la nature de la barrière. La structure des barrières peut se baser, de façon non exhaustive, sur un matériau isolant ou métallique non supraconducteur, ou sur une singularité géométrique ou encore sur un joint de grains. Les jonctions correspondantes peuvent être de type « tunnel », « constriction » ou « point de contact », « tout matériau non supraconducteur » ou encore une jonction de grains.

Certaines jonctions à effet tunnel ont typiquement une structure de type SIS (supraconducteur - isolant - supraconducteur) ; dans ces jonctions le mécanisme de transport est essentiellement dominé par l'effet tunnel corrélé des électrons qui forment une paire de Cooper à travers la barrière isolante. Dans une jonction SNS (supraconducteur - métal normal - supraconducteur) le mécanisme de transport est dominé essentiellement par l'effet de proximité. En général à l'interface entre un supraconducteur et un métal normal la cohérence quantique se maintient aussi dans le métal normal sous une distance définie par la longueur de cohérence de phase.

La fabrication industrielle de jonctions Josephson dans un circuit intégré supraconducteur est un enjeu majeur pour le développement de l'électronique quantique.

Le document EP3577700 propose par exemple d'utiliser une construction tricouche de type SIS intégrée au sein de différents niveaux de métaux, typiquement dans des niveaux d'interconnexions dits « de fin de ligne » ou « BEOL » (acronyme de « Back End of Line »). La tricouche SIS est ici une tricouche Nb/Al-AlOx/Nb, avec des couches supérieure et inférieure supraconductrices comprenant du niobium, et une couche intermédiaire comprenant de l'aluminium supraconductrice également et une fine couche barrière d'oxyde d'aluminium.

Cette solution connue nécessite un nombre d'étapes important. Le coût du procédé est augmenté. Il existe donc un besoin visant à optimiser le procédé de réalisation de JJ au moins en partie intégrées dans le « Back End ».

Un objet de la présente invention est de répondre à ce besoin, en palliant tout ou partie des inconvénients mentionnés ci-dessus.

En particulier, un objet de la présente invention est de proposer un procédé de formation de JJ intégrées dans des niveaux d'interconnexions, qui soit industrialisable et qui présente un coût réduit.

### RESUME

Pour atteindre cet objectif, selon un mode de réalisation on prévoit un procédé de fabrication d'une jonction Josephson comprenant :
- une fourniture d'un substrat comprenant au moins un premier plot de connexion et un deuxième plot de connexion,
- une formation d'au moins une première couche métallique supraconductrice sur des faces exposées des premier et deuxième plots de connexion,
- une formation, sur l'au moins une première couche métallique supraconductrice, d'au moins une couche d'arrêt de gravure,
- une structuration de l'au moins une couche d'arrêt de gravure, par l'intermédiaire d'au moins un premier masque, de façon à exposer des parties de l'au moins une première couche métallique supraconductrice et à conserver des parties de l'au moins une couche d'arrêt de gravure sous forme d'au moins un motif fermé surmontant le premier plot de connexion et au moins un motif ouvert surmontant le deuxième plot de connexion, ledit au moins un motif ouvert comprenant au moins une ouverture de via débouchant sur l'au moins une première couche métallique supraconductrice sous-jacente,
- une formation d'au moins une deuxième couche métallique supraconductrice sur les parties exposées de l'au moins une première couche métallique supraconductrice et sur l'au moins un motif fermé et l'au moins un motif ouvert,
- une formation, sur l'au moins une deuxième couche métallique supraconductrice, d'au moins un deuxième masque définissant au moins un niveau de vias à l'aplomb de l'au moins un motif fermé et à l'aplomb de l'au moins une ouverture de via de l'au moins un motif ouvert,
- une gravure de l'au moins une deuxième couche métallique supraconductrice, ladite gravure étant configurée pour former les vias de l'au moins un niveau de vias en s'arrêtant sur les motifs de l'au moins une couche d'arrêt de gravure et,
- une gravure de l'au moins une première couche métallique supraconductrice de part et d'autre de l'au moins un motif fermé et de l'au moins un motif ouvert, ladite gravure étant configurée pour former des lignes de niveau inférieur en s'arrêtant sur le substrat,

Avantageusement, l'au moins un motif fermé de l'au moins une couche d'arrêt de gravure comprend une couche barrière à base d'un matériau de jonction Josephson présentant, vis-à-vis de l'au moins une première couche métallique supraconductrice, une sélectivité S_{20a:30a} à la gravure supérieure ou égale à 10:1.

Les vias du deuxième niveau surmontant les motifs ouverts sont connectés aux lignes du premier niveau au travers de l'au moins une ouverture de via. Ces lignes du premier niveau sont elles-mêmes connectées aux plots du substrat. Des interconnexions vers les plots du substrat sont ainsi formées au travers de plusieurs niveaux métalliques.

Les vias du deuxième niveau surmontant les motifs fermés sont séparés des lignes du premier niveau par le matériau de jonction Josephson. Une jonction Josephson est ainsi formée entre plusieurs niveaux métalliques supraconducteurs.

Un dispositif quantique comprenant des interconnexions et au moins une jonction Josephson intégrée dans le « Back End » est avantageusement réalisé. Les formations des interconnexions et de la ou des jonctions Josephson se font avantageusement lors des mêmes étapes de gravure.

Ce procédé recourt à une couche barrière structurée et enterrée entre les première et deuxième couches métalliques supraconductrices. Cette couche barrière, qui présente une sélectivité S_{21:30a} à la gravure supérieure ou égale à 10:1, fait avantageusement office de couche d'arrêt de gravure. Une telle couche d'arrêt de gravure intercalaire permet avantageusement d'effectuer la ou les gravures des couches métalliques supraconductrices successivement, par exemple en une seule étape ou de façon enchaînée. Le nombre d'étapes du procédé est ainsi limité.

L'invention prévoit également selon un deuxième aspect un dispositif typiquement issu de ce procédé de fabrication. Ce dispositif quantique comprend, en empilement suivant une direction z :
- un substrat comprenant au moins un premier plot de connexion et un deuxième plot de connexion,
- une interconnexion connectant le deuxième plot de connexion, comprenant :
   - au moins une ligne métallique supraconductrice à base d'un premier métal supraconducteur, et,
   - au moins un via métallique à base d'un deuxième métal supraconducteur, connecté à ladite au moins une ligne métallique,
   - une couche barrière intercalée entre l'au moins un via et l'au moins une ligne, ladite couche barrière comprenant au moins une ouverture de via de sorte que l'au moins un via et l'au moins une ligne sont connectés au travers de ladite au moins une ouverture de via,
- une jonction de Josephson connectant le premier plot de connexion, comprenant :
   - au moins une ligne métallique à base du premier métal supraconducteur, et,
   - au moins un via métallique à base du deuxième métal supraconducteur,
   - une couche barrière intercalée entre l'au moins un via et l'au moins une ligne, ladite couche barrière séparant l'au moins un via et l'au moins une ligne.

Les avantages décrits ci-dessus en regard du procédé s'appliquent *mutatis mutandis* au dispositif selon l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 12A illustrent schématiquement en coupe transverse, dans un plan xz, différentes étapes du procédé de fabrication d'une jonction Josephson selon un premier mode de réalisation de la présente invention.
Les figures 1B à 12B illustrent schématiquement en perspective, les étapes du procédé de fabrication d'une jonction Josephson illustrées respectivement aux figures 1A à 12A, selon le premier mode de réalisation de la présente invention.
Les figures 13A, 13B illustrent schématiquement un dispositif comprenant plusieurs JJ en parallèle selon un mode de réalisation de la présente invention.
Les figures 14A à 18A illustrent schématiquement en coupe transverse, dans un plan xz, différentes étapes du procédé de fabrication d'une jonction Josephson selon un deuxième mode de réalisation de la présente invention.
Les figures 14B à 18B illustrent schématiquement en perspective, les étapes du procédé de fabrication d'une jonction Josephson illustrées respectivement aux figures 14A à 18A, selon le deuxième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches et motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'au moins une couche d'arrêt de gravure présente, vis-à-vis de l'au moins une première couche métallique supraconductrice, une sélectivité S_{20a:30} à la gravure supérieure ou égale à 10:1.
Selon un exemple, la couche barrière présente une épaisseur e₃₀ₐ comprise entre 1 nm et 10 nm et préférentiellement entre 1 nm et 5 nm.
Selon un exemple, la couche barrière présente une sélectivité à la gravure S_{21:32a} ou S_{21:31} supérieure ou égale à 10:1 vis-à-vis du premier métal supraconducteur.
Selon un exemple, la couche barrière est à base d'un matériau pris parmi : MgO, SiO₂, AlOₓ, TiO₂.
Selon un exemple, la couche barrière intercalée entre l'au moins un via et l'au moins une ligne de la jonction de Josephson est continue et ne comprend pas d'ouverture de via.
Selon un exemple, la structuration de la couche barrière comprend les sous-étapes suivantes :
   - une formation du premier masque sur la couche barrière, ledit premier masque définissant de façon directe l'au moins un motif fermé et l'au moins un motif ouvert comprenant l'au moins une ouverture de via,
   - un retrait partiel de la couche barrière, uniquement au niveau de zones de la couche barrière non couvertes par le premier masque, de façon à exposer la première couche métallique supraconductrice en dehors des zones couvertes par le premier masque,
   - un retrait du premier masque.

Dans cet exemple, les parties couvertes par le premier masque correspondent aux motifs ouverts et fermés. La partie inférieure de la jonction de Josephson et les lignes du premier niveau participant aux interconnexions sont définies grâce au seul premier masque.

Selon un exemple, la formation du premier masque se fait par double lithographie. Ce procédé connu de lithographie permet d'optimiser, voire de dépasser les limitations en résolution d'un équipement d'insolation classique de lithographie. Une autre solution consiste à utiliser un équipement de lithographie mieux résolu, par exemple en extrême UV ou en lithographie électronique. La formation du premier masque peut comprendre une première lithographie suivie d'une deuxième lithographie, puis une gravure. Alternativement, la formation du premier masque peut comprendre une première lithographie suivie d'une première gravure, puis une deuxième lithographie suivie d'une deuxième gravure.

Selon un exemple, le ou les vias de l'au moins un niveau de vias surmontant le ou les motifs fermés présentent une dimension critique CDᵥᵢₐ₂₂₁, prise selon un axe x, inférieure à une dimension CD₁, prise selon l'axe x, du ou des motifs fermés. Cela permet de minimiser le risque lié à un désalignement entre les premier et deuxième masques. Les lignes du premier niveau étant typiquement plus larges que les vias du deuxième niveau, la gravure de la deuxième couche métallique supraconductrice, associée à la formation des vias du deuxième niveau, s'arrêtera effectivement sur la couche barrière, structurée selon le ou les motifs fermés. La fiabilité du procédé est augmentée.

Selon un exemple, le ou les vias de l'au moins un niveau de vias surmontant le ou les motifs ouverts présentent une dimension critique CDᵥᵢₐ₂₂₂, prise selon un axe x, supérieure ou égale à une dimension CDₒₚₑₙ de l'au moins une ouverture de via prise selon l'axe x. Cela permet de minimiser le risque lié à un désalignement entre les premier et deuxième masques. Les vias de l'au moins un niveau de vias étant typiquement plus larges que les ouvertures de via, l'alignement du deuxième masque définissant les vias à l'aplomb des ouvertures de via est facilité. La gravure de la deuxième couche métallique supraconductrice, lors de la formation des vias de l'au moins un niveau de vias, s'arrêtera effectivement sur la couche d'arrêt de gravure ou sur la couche barrière, structurée selon le ou les motifs ouverts. La gravure de la deuxième couche métallique supraconductrice ne se prolonge pas au niveau des ouvertures de via. La fiabilité du procédé est augmentée.

Selon un exemple, les première et deuxième couches métalliques supraconductrices sont à base d'un même matériau métallique supraconducteur, par exemple ZrN, HfN, W, Nb, NbN, Ta, TaN, Ti, TiN, Al et leurs alliages.

Selon un exemple, la gravure de la deuxième couche métallique supraconductrice et la gravure de la première couche métallique supraconductrice sont réalisées par une seule et même gravure, lors d'une seule et même étape.

Selon un exemple, les première et deuxième couches métalliques supraconductrices sont respectivement à base d'un premier matériau métallique supraconducteur et d'un deuxième matériau métallique supraconducteur, lesdits premier et deuxième matériaux métalliques supraconducteurs étant différents entre eux.

Selon un exemple, la gravure de la deuxième couche métallique supraconductrice et la gravure de la première couche métallique supraconductrice sont réalisées par deux gravures successives différentes.

Selon un exemple, l'au moins un motif fermé comprend un premier motif fermé et un deuxième motif fermé, lesdits motifs fermé étant surmontés respectivement par des troisième et quatrième vias. Selon un exemple, le procédé comprend en outre, après formation de l'ensemble des vias de l'au moins un niveau de vias et de l'ensemble des lignes de niveau inférieur, une formation d'au moins une ligne métallique supraconductrice de niveau supérieur reliant les troisième et quatrième vias, de façon à former un dispositif comprenant plusieurs jonctions Josephson. Selon un principe de l'invention, plusieurs jonctions Josephson « verticales » peuvent être formées côte à côte, entre des interconnexions supraconductrices. Il est ainsi possible de relier deux jonctions Josephson adjacentes.

Selon un exemple, on prévoit un procédé de fabrication d'une jonction Josephson comprenant :
- une fourniture d'un substrat comprenant au moins un premier plot de connexion et un deuxième plot de connexion,
- une formation d'une première couche métallique supraconductrice sur des faces exposées des premier et deuxième plots de connexion,
- une formation, sur la première couche métallique supraconductrice, d'une couche barrière à base d'un matériau de jonction Josephson présentant, vis-à-vis de la première couche métallique supraconductrice, une sélectivité S_{21:30a} à la gravure supérieure ou égale à 10:1,
- une structuration de la couche barrière, par l'intermédiaire d'au moins un premier masque, de façon à exposer des parties de la première couche métallique supraconductrice et à conserver des parties de la couche barrière sous forme d'au moins un motif fermé surmontant le premier plot de connexion et au moins un motif ouvert surmontant le deuxième plot de connexion, ledit au moins un motif ouvert comprenant au moins une ouverture de via débouchant sur la première couche métallique supraconductrice sous-jacente,
- une formation d'une deuxième couche métallique supraconductrice sur les parties exposées de la première couche métallique supraconductrice et sur l'au moins un motif fermé et l'au moins un motif ouvert,
- une formation, sur la deuxième couche métallique supraconductrice, d'un deuxième masque définissant un deuxième niveau de vias à l'aplomb de l'au moins un motif fermé et à l'aplomb de l'au moins une ouverture de via de l'au moins un motif ouvert,
- une gravure de la deuxième couche métallique supraconductrice, ladite gravure étant configurée pour former les vias du deuxième niveau en s'arrêtant sur la couche barrière et,
- une gravure de la première couche métallique supraconductrice de part et d'autre de l'au moins un motif fermé et de l'au moins un motif ouvert, ladite gravure étant configurée pour former des lignes de premier niveau en s'arrêtant sur le substrat.

Dans cet exemple, la couche barrière est avantageusement utilisée comme couche barrière pour la jonction Josephson et comme couche d'arrêt de gravure pour la réalisation des lignes et des vias d'interconnexion. Une seule et même couche est utilisée pour remplir les fonctions de barrière dans la jonction Josephson et d'arrêt de gravure dans la structuration des niveaux de métal supraconducteur des interconnexions. Le nombre d'étapes du procédé est significativement réduit. Le coût du procédé est diminué.

Selon un exemple, la première couche métallique supraconductrice et/ou la deuxième couche métallique supraconductrice se présentent sous forme d'empilements comprenant plusieurs matériaux supraconducteurs, par exemple sous forme de multi-couches. Cela permet par exemple de bénéficier des qualités ou des propriétés de chacun de ces matériaux. Une température critique élevée, due à un premier matériau supraconducteur, peut ainsi être obtenue par effet de proximité dans un deuxième matériau supraconducteur utilisé pour la qualité d'interface qu'il forme avec la couche barrière.

Selon un exemple, on prévoit un procédé de fabrication d'une jonction Josephson comprenant :
- une fourniture d'un substrat comprenant au moins un premier plot de connexion et un deuxième plot de connexion,
- une formation d'une première couche métallique supraconductrice sur des faces exposées des premier et deuxième plots de connexion,
- une formation, sur la première couche métallique supraconductrice, d'une couche d'arrêt de gravure présentant, vis-à-vis de la première couche métallique supraconductrice, une sélectivité S_{21:30b} à la gravure supérieure ou égale à 10:1,
- une structuration de la couche d'arrêt de gravure, par l'intermédiaire d'au moins un premier masque, de façon à exposer des parties de la première couche métallique supraconductrice et à conserver des parties de la couche d'arrêt de gravure sous forme d'au moins un motif ouvert surmontant les premier et deuxième plots de connexion, ledit au moins un motif ouvert comprenant au moins une ouverture de via débouchant sur la première couche métallique supraconductrice sous-jacente,
- une formation d'une deuxième couche métallique supraconductrice sur les parties exposées de la première couche métallique supraconductrice et sur l'au moins un motif ouvert,
- une formation, sur la deuxième couche métallique supraconductrice, d'une couche barrière à base d'un matériau de jonction Josephson présentant, vis-à-vis de la deuxième couche métallique supraconductrice, une sélectivité S_{22:30a} à la gravure supérieure ou égale à 10:1,
- une structuration de la couche barrière, par l'intermédiaire d'au moins un deuxième masque, de façon à exposer des parties de la deuxième couche métallique supraconductrice et à conserver des parties de la couche barrière sous forme d'au moins un motif fermé surmontant le premier plot de connexion,
- une formation d'une troisième couche métallique supraconductrice sur les parties exposées de la deuxième couche métallique supraconductrice et sur l'au moins un motif fermé,
- une formation, sur la troisième couche métallique supraconductrice, d'un troisième masque définissant des vias à l'aplomb de l'au moins un motif fermé et à l'aplomb de l'au moins une ouverture de via de l'au moins un motif ouvert,
- au moins une gravure des troisième, deuxième et première couches métalliques supraconductrices, ladite au moins une gravure étant configurée pour former les vias en s'arrêtant sur la couche barrière et sur la couche d'arrêt de gravure, et pour former des lignes de premier niveau en s'arrêtant sur le substrat.

Dans cet exemple, la partie inférieure de la jonction Josephson est formée à partir des première et deuxième couches métalliques supraconductrices. Les lignes du premier niveau participant aux interconnexions sont formées à partir de la première couche métallique supraconductrice.

Dans cet exemple, la jonction Josephson est formée au sein des niveaux d'interconnexions supérieurs. La couche barrière forme uniquement le motif fermé. La couche d'arrêt de gravure sous-jacente forme un motif ouvert. Cela permet d'envisager différentes combinaisons de motifs fermés et ouverts. Le dimensionnement de la partie inférieure de la jonction Josephson et/ou de la couche barrière de la jonction Josephson est mieux contrôlé. La sélectivité de gravure entre les différentes couches métalliques supraconductrices et la couche barrière peut être ajustée, par exemple réduite.

Selon un exemple, l'au moins un motif fermé présente une dimension CD₁, prise selon un axe x, inférieure à une dimension CD₂, prise selon l'axe x, de l'au moins un motif ouvert sous-jacent.

Selon un exemple, l'au moins un via métallique de l'interconnexion connectant le deuxième plot de connexion présente une dimension critique CDᵥᵢₐ₂₂₂, prise selon un axe x, supérieure ou égale à une dimension CDₒₚₑₙ de l'au moins une ouverture de via prise selon l'axe x.

Selon un exemple, l'au moins un via métallique de la jonction de Josephson présente une dimension critique CDᵥᵢₐ₂₂₁, prise selon un axe x, strictement inférieure à une dimension CD₃₁, prise selon l'axe x, de la couche barrière séparant l'au moins un via et l'au moins une ligne de la jonction de Josephson.

Selon un exemple, les premier et deuxième métaux supraconducteurs sont à base du même métal pris parmi ZrN, HfN, W, Nb, NbN, Ta, TaN, Ti, TiN, Al et leurs alliages.

Selon un exemple, l'au moins une ligne métallique supraconductrice de l'interconnexion est connectée au deuxième plot de connexion. Selon un exemple, l'au moins une ligne métallique supraconductrice de la jonction de Josephson est connectée au premier plot de connexion.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, une couche d'arrêt de gravure à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

On entend par motif fermé un motif qui ne communique pas avec la couche sous-jacente. A contrario, on entend par motif ouvert un motif qui communique avec la couche sous-jacente à travers une ouverture, typiquement à travers une ouverture de via.

Dans le cadre de la présente invention, une barrière peut être vue comme une description structurelle et une jonction peut être vue comme une description fonctionnelle de la même entité. Une barrière s'entend d'une barrière formée d'un matériau non-supraconducteur. Un « matériau de jonction Josephson » peut être un matériau diélectrique ou un métal non supraconducteur.

Les réalisations de jonctions Josephson envisagées dans la présente invention sont particulièrement adaptées au domaine des Jonctions Josephson Tunnels. D'autres domaines applicatifs sont parfaitement envisageables.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé. Les gravures des première et deuxième couches métalliques peuvent notamment être enchaînées ou être considérées comme faisant partie d'une seule et même étape de gravure.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche métallique présente typiquement une épaisseur selon z. Un via formé à partir d'une telle couche métallique présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

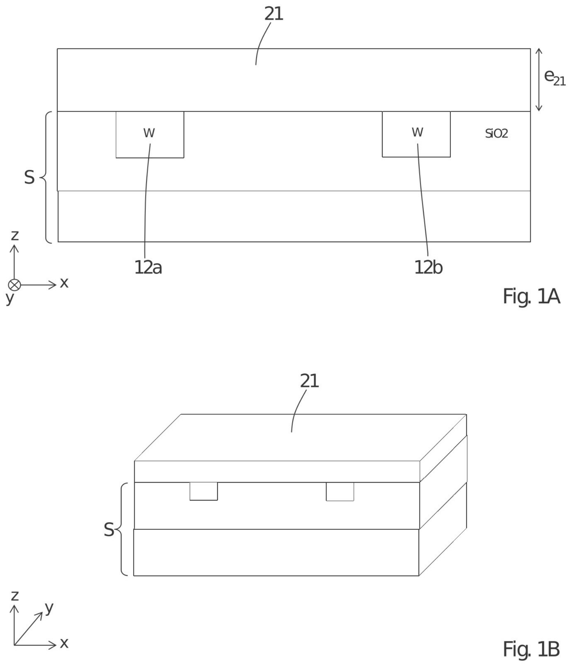

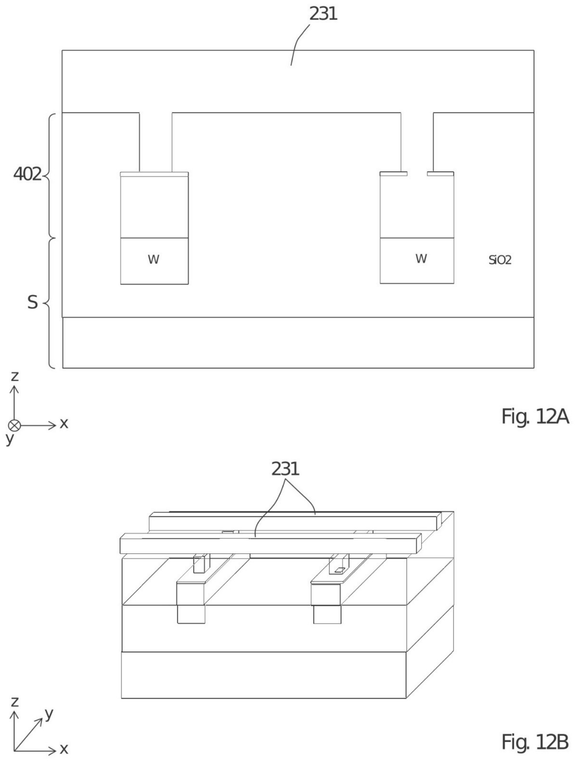

Des étapes de fabrication d'un dispositif comprenant une jonction Josephson (JJ) intégrée dans un niveau d'interconnexions sont illustrées aux figures 1A, 1B à 12A, 12B, selon un premier mode de réalisation de l'invention.

Comme illustré aux figures 1A, 1B, le procédé comprend une fourniture d'un substrat S, par exemple à base de silicium, comprenant des plots de connexion 12a, 12b. Les plots de connexion 12a, 12b peuvent correspondre à un niveau de lignes d'interconnexions intermédiaire de type MEOL (acronyme de « Middle End of Line »).

Une première couche métallique supraconductrice 21, typiquement à base d'un métal pris parmi ZrN, HfN, W, Nb, NbN, Ta, TaN, Ti, TiN, Al et leurs alliages, est d'abord formée sur ce substrat S. Cette couche métallique supraconductrice 21 est directement au contact des plots de connexion 12a, 12b. Cette couche métallique supraconductrice 21 présente typiquement une épaisseur e₂₁ de l'ordre de quelques dizaines de nanomètres à quelques centaines de nanomètres, par exemple entre 40 nm et 200 nm. Le dépôt de cette couche métallique supraconductrice 21 peut notamment être effectué par l'une des techniques suivantes: dépôt physique en phase vapeur (PVD, acronyme de « physical vapor deposition »), dépôt chimique en phase vapeur (CVD, acronyme de « chemical vapor deposition »), dépôt par couche atomique (ALD, acronyme de « atomic layer deposition »). Après dépôt, la première couche métallique supraconductrice 21 peut être planarisée, par exemple par polissage mécano-chimique CMP. La première couche métallique supraconductrice 21 correspond typiquement à un premier niveau de métal supraconducteur.

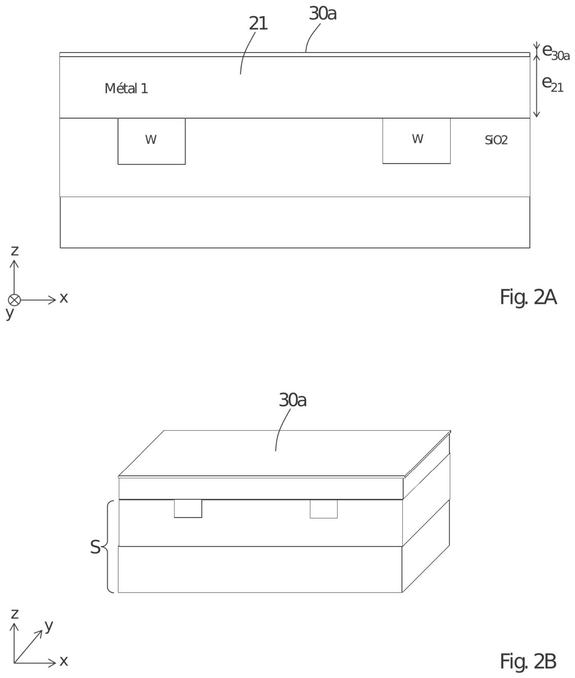

Comme illustré aux figures 2A, 2B, une couche barrière 30a est ensuite directement formée sur la première couche métallique supraconductrice 21. Cette couche barrière 30a présente typiquement une épaisseur e₃₀ₐ de l'ordre de quelques nanomètres, par exemple entre 5 nm et 15 nm. Elle est à base d'un matériau « de jonction Josephson », non supraconducteur, par exemple à base d'un matériau pris parmi : MgO, SiO₂, AlOₓ, TiO₂. Le dépôt de cette couche barrière 30a peut notamment être effectué par l'une des techniques suivantes : dépôt physique en phase vapeur (PVD, acronyme de « physical vapor deposition »), dépôt chimique en phase vapeur (CVD, acronyme de « chemical vapor deposition »), dépôt chimique en phase vapeur assisté par plasma (PECVD, acronyme de « plasma enhanced chemical vapor deposition »), dépôt par couche atomique (ALD, acronyme de « atomic layer deposition »), dépôt par couche atomique assisté par plasma (PEALD, acronyme de « plasma enhanced atomic layer deposition »).

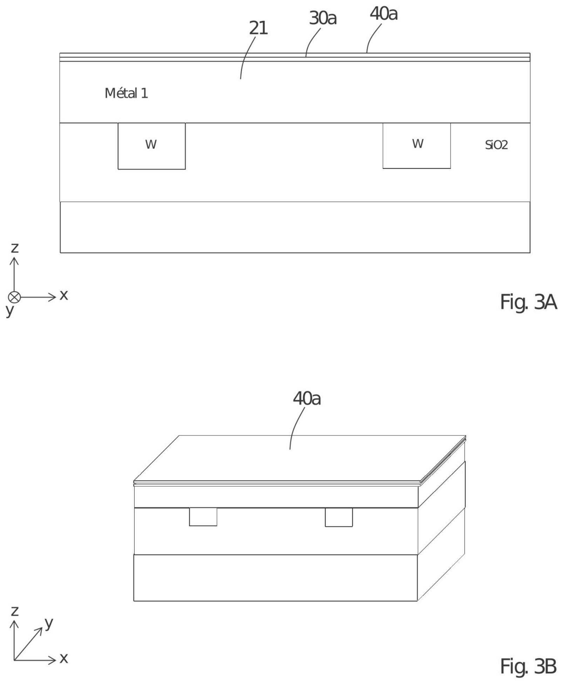

Comme illustré aux figures 3A, 3B, de façon optionnelle uniquement, une couche de protection 40a peut être déposée sur la couche barrière 30a, pour préserver ladite couche barrière 30a de l'oxydation.

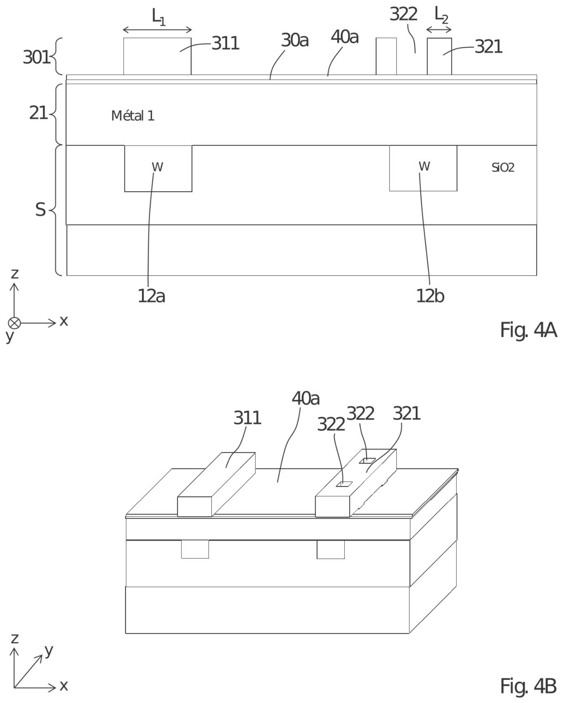

Comme illustré aux figures 4A, 4B, un masque de gravure 301 est formé sur la couche barrière 30a. Ce masque de gravure 301 est par exemple à base de SiON, par exemple sous forme d'un empilement connu sous la dénomination « trilayer », comprenant typiquement une couche de planarisation organique, une couche antireflets et une couche de résine photosensible. Il est typiquement obtenu par lithographie/gravure, par exemple par l'intermédiaire d'une lithographie simple en insolation extrême UV, ou par l'intermédiaire d'une double lithographie, également appelée « double patterning ».

Le masque de gravure 301 comprend un motif plein 311 au-dessus du plot de connexion 12a, et un motif ouvert 321 au-dessus du plot de connexion 12b. Le motif ouvert 321 comprend une ou plusieurs ouvertures 322 débouchant sur la couche sous-jacente, par exemple la couche de protection 40a comme illustré ici, ou directement sur la couche barrière 30a. Le motif plein 311 présente typiquement une dimension L₁ selon x comprise entre 20 nm et 300 nm, de préférence entre 20 nm et 150 nm, en fonction de la technique de lithographie mise en œuvre. Le motif ouvert 321 présente typiquement une dimension L₂ selon x comprise entre 8 nm et 150 nm, de préférence entre 8 nm et 50 nm, en fonction de la technique de lithographie mise en œuvre.

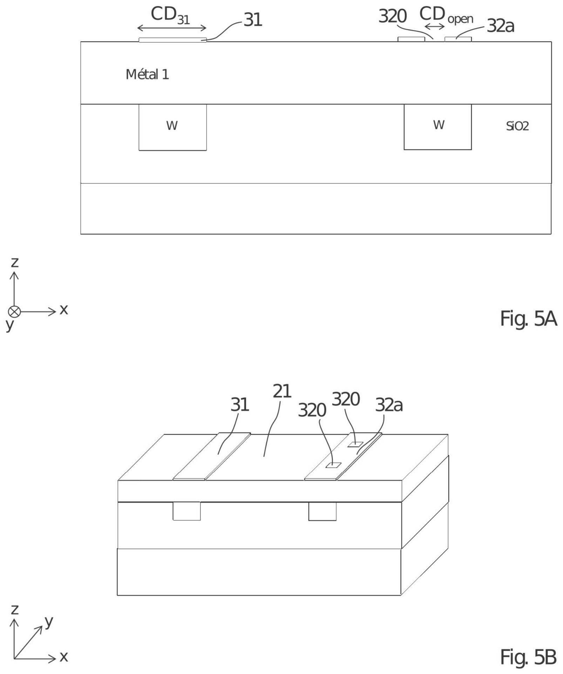

Comme illustré aux figures 5A, 5B, les motifs 311, 321 sont transférés dans la couche barrière 30a par gravure anisotrope selon z de la couche barrière 30a en présence du masque 301. La gravure de la couche barrière 30a peut être effectuée par plasma à base d'une chimie de gravure halogénée, par exemple à base d'une chimie chlorée. Alternativement, la gravure du matériau « de jonction Josephson » peut être effectuée en chimie fluorée ou fluoro-carbonée. Dans ce cas, il est préférable d'éviter SiN et SiO2 comme matériau de jonction Josephson. Le motif plein 311 du masque 301 forme après gravure le motif fermé 31 dans la couche barrière 30a. Le motif ouvert 321 du masque 301 forme après gravure le motif ouvert 32a comprenant les ouvertures de via 320 dans la couche barrière 30a. Les motifs 31, 32a présentent sensiblement les mêmes dimensions que les motifs 311, 321. Le motif fermé 31 présente typiquement la dimension CD₃₁ selon x, et les ouvertures de via 320 du motif ouvert 32a présentent typiquement la dimension CDₒₚₑₙ selon x. La dimension CDₒₚₑₙ selon x peut être comprise entre 10 nm et 100 nm, de préférence entre 10 nm et 50 nm, en fonction de la technique de lithographie mise en œuvre. Le masque 301 est retiré après gravure, par exemple par plasma à base d'oxygène. La couche de protection 40a est également retirée le cas échéant, par exemple par plasma NF₃ ou NH₃ in-situ, de façon à exposer les motifs 31, 32a de la couche barrière 30a.

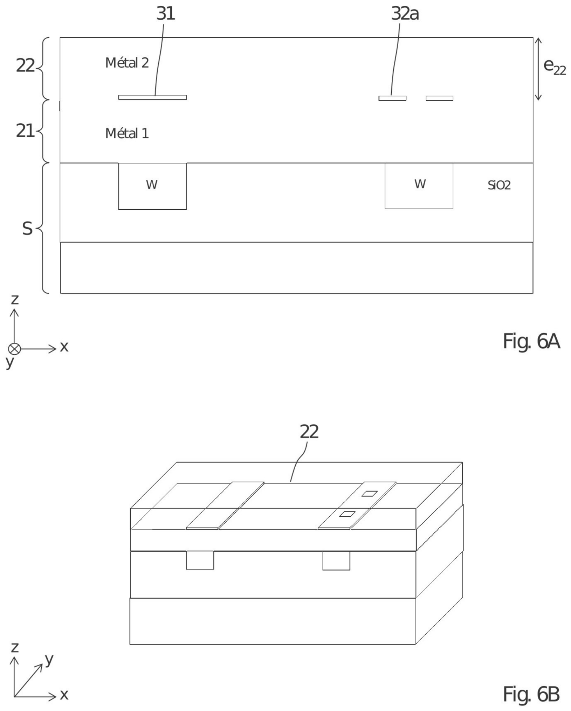

Comme illustré aux figures 6A, 6B, après structuration de la couche barrière 30a, une deuxième couche métallique supraconductrice 22, typiquement à base d'un métal pris parmi ZrN, HfN, W, Nb, NbN, Ta, TaN, Ti, TiN, Al et leurs alliages, est ensuite formée sur la première couche métallique supraconductrice 21, et sur le motif fermé 31 et le motif ouvert 32a. Cette couche métallique supraconductrice 22 présente typiquement une épaisseur e₂₂ de l'ordre de quelques dizaines de nanomètres à quelques centaines de nanomètres, par exemple entre 40 nm et 200 nm. Le dépôt de cette couche métallique 22 peut notamment être effectué par PVD, CVD, PECVD, ALD ou PEALD. Après dépôt, la deuxième couche métallique supraconductrice 22 peut être planarisée, par exemple par CMP. La deuxième couche métallique supraconductrice 22 correspond typiquement à un deuxième niveau de métal supraconducteur.

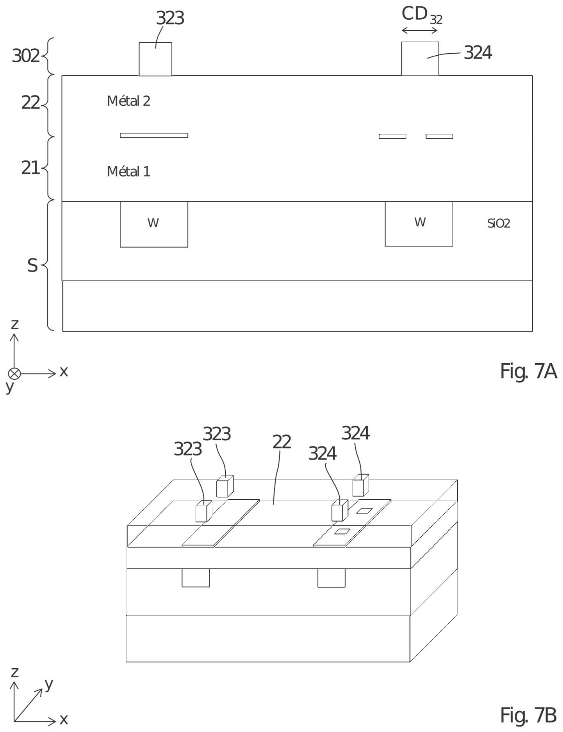

Comme illustré aux figures 7A, 7B, un deuxième masque de gravure 302 comprenant des motifs de vias 323, 324 est formé sur la deuxième couche métallique supraconductrice 22. Ce deuxième masque de gravure 302 est de préférence à base de couches organiques, par exemple sous forme d'un empilement « trilayer », comprenant typiquement une couche de planarisation organique, une couche antireflets et une couche de résine photosensible.

Les motifs de vias 324 de ce deuxième masque de gravure 302 sont alignés à l'aplomb des ouvertures de via 320 du motif ouvert 32a. Les motifs de via 323 de ce deuxième masque de gravure 302 sont alignés à l'aplomb du motif fermé 31. Les motifs de vias 324 présentent typiquement une dimension CD₃₂ selon x légèrement supérieure, par exemple 10% supérieure, à la dimension CDₒₚₑₙ selon x des ouvertures de via 320 du motif ouvert 32a. Cela facilite l'alignement des motifs 324, 32a entre eux. Une certaine tolérance sur la précision d'alignement est ainsi obtenue. La dimension CD₃₂ selon x des motifs de vias 324 est par exemple comprise entre 10 nm et 150 nm.

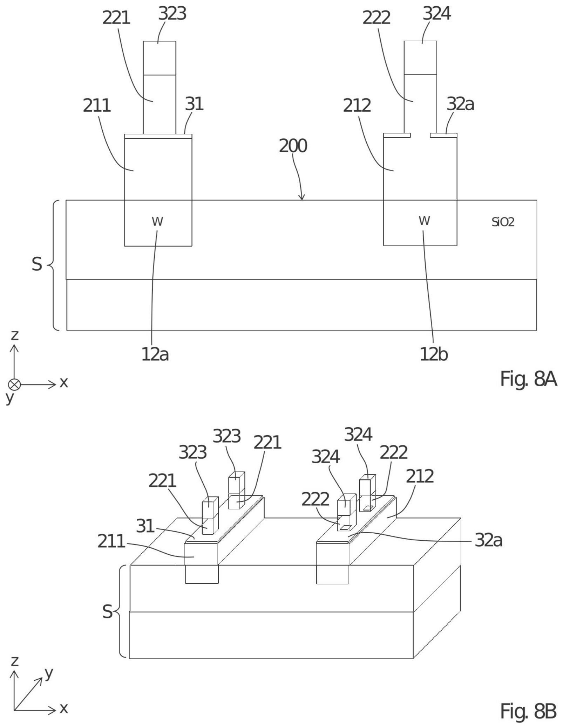

Comme illustré aux figures 8A, 8B, les première et deuxième couches métalliques supraconductrices 21, 22 sont ensuite gravées sur toute leur épaisseur, selon z, de part et d'autre des motifs de vias 323, 324 et de part et d'autre du motif ouvert 32a et du motif fermé 31. La deuxième couche métallique supraconductrice 22 est d'abord gravée pour former les vias 222, 221, puis la première couche métallique supraconductrice 21 est gravée pour former les lignes 212, 211. Les gravures des première et deuxième couches métalliques supraconductrices 21, 22 sont de préférence enchaînées. Selon une possibilité, notamment lorsque les première et deuxième couches métalliques supraconductrices 21, 22 sont de nature identique, les gravures de ces couches métalliques supraconductrices 21, 22 sont effectuées en une seule et même étape, avec la même chimie de gravure.

Les gravures sont ici choisies de façon à graver sélectivement les premier et deuxième métaux des première et deuxième couches métalliques supraconductrices 21, 22 vis-à-vis du matériau de la couche barrière (structurée sous forme des motifs 31, 32a). La couche barrière est ici avantageusement utilisée comme couche d'arrêt de gravure. En particulier, la sélectivité de gravure S_{21:30a}, c'est-à-dire le rapport entre la vitesse de gravure du métal de la première couche métallique supraconductrice 21 sur la vitesse de gravure du matériau de la couche barrière, est supérieure ou égale à 10:1, de préférence supérieure ou égale à 10:1. Les gravures peuvent être à base d'une chimie fluorée.

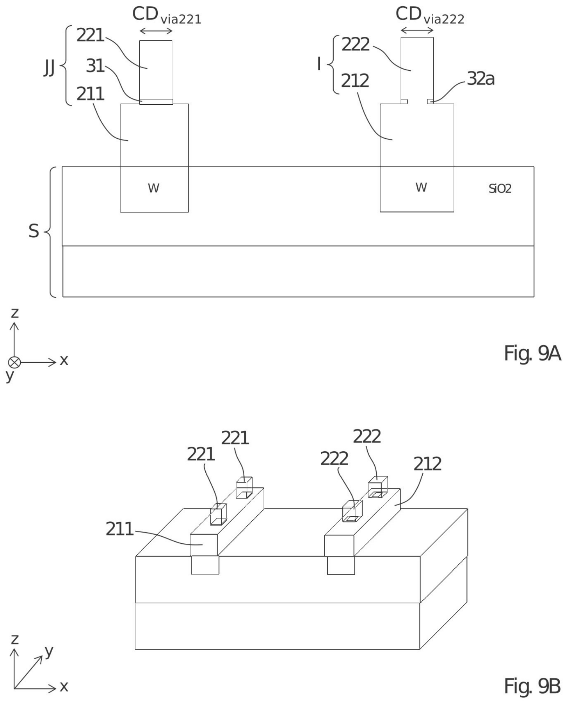

Comme illustré aux figures 9A, 9B, après gravure, le masque 302 est retiré, par exemple par plasma à base d'oxygène. Des vias 222 présentant la dimension CDᵥᵢₐ₂₂₂ selon x sont obtenus au-dessus des ouvertures du motif ouvert 32a. La dimension CDᵥᵢₐ₂₂₂ est sensiblement égale à la dimension CD₃₂ des motifs de vias 324. Des vias 221 présentant la dimension CDᵥᵢₐ₂₂₁ selon x sont obtenus au-dessus du motif fermé 31. Un dispositif quantique comprenant des interconnexions I (212, 222) et une ou plusieurs jonctions Josephson JJ (211, 31, 221) intégrées dans les niveaux d'interconnexions est ainsi avantageusement obtenu. Les jonctions Josephson JJ comprennent ici une partie inférieure formée par la ligne 211, une partie supérieure formée par le via 221, et une barrière 31 entre les parties inférieure et supérieure. Les jonctions Josephson JJ sont ici intégrées entre les premier et deuxième niveaux de métal supraconducteur.

Dans l'exemple illustré aux figures 9A, 9B, selon une possibilité uniquement optionnelle, une gravure anisotrope selon z est effectuée pour retirer partiellement la couche barrière, de part et d'autre des vias 221, 222. Les lignes 211, 212 présentent ici des surfaces horizontales partiellement exposées.

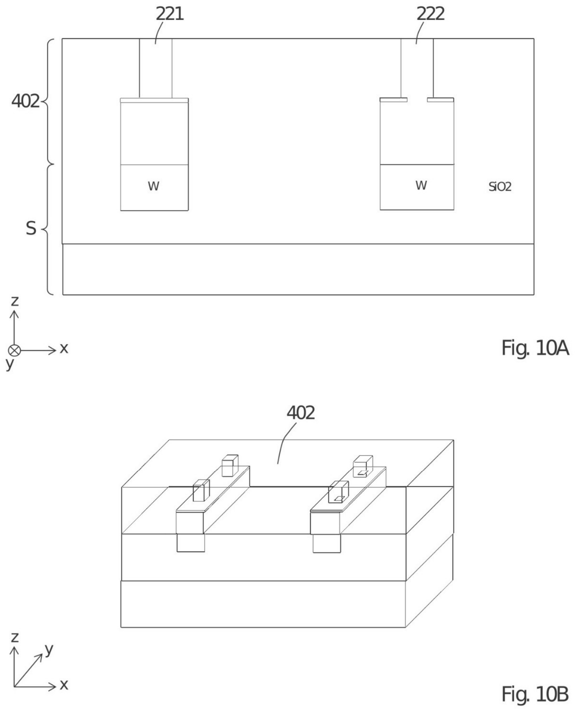

Comme illustré aux figures 10A, 10B, les interconnexions I et les jonctions Josephson JJ sont ensuite classiquement intégrés dans une matrice diélectrique par dépôt et planarisation d'une couche diélectrique 402, typiquement à base de SiO₂.

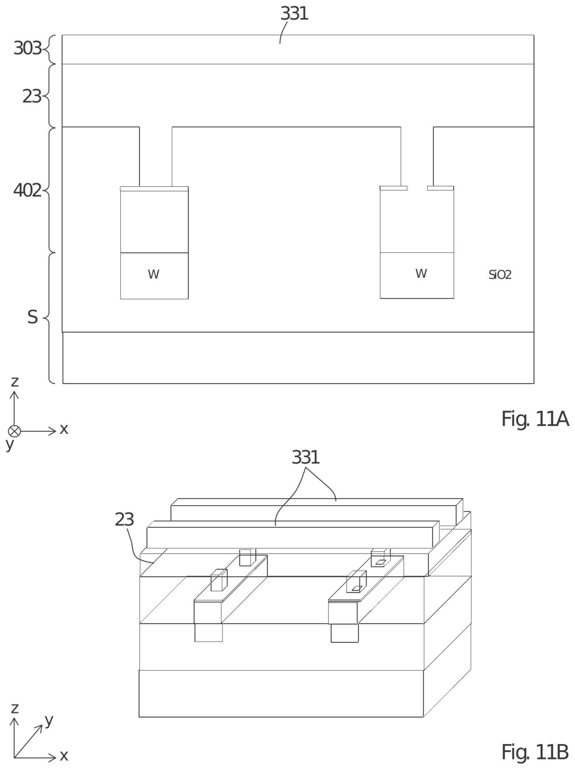

Comme illustré aux figures 11A, 11B, une troisième couche métallique supraconductrice 23 par exemple à base de ZrN, HfN, W, Nb, NbN, Ta, TaN, Ti, TiN, Al et leurs alliages, correspondant à un troisième niveau de métal supraconducteur, peut ensuite être déposée sur la couche 402 et les vias 221, 222 affleurant. Un troisième masque 303 comprenant par exemple des motifs de ligne 331 peut être formé sur cette troisième couche métallique supraconductrice 23.

Comme illustré aux figures 12A, 12B, la troisième couche métallique supraconductrice 23 est ensuite structurée par gravure au travers du masque 303. Des lignes 231 sont ainsi formées dans le troisième niveau de métal supraconducteur. Ces lignes 231 connectent typiquement les vias 221, 222 du deuxième niveau de métal supraconducteur.

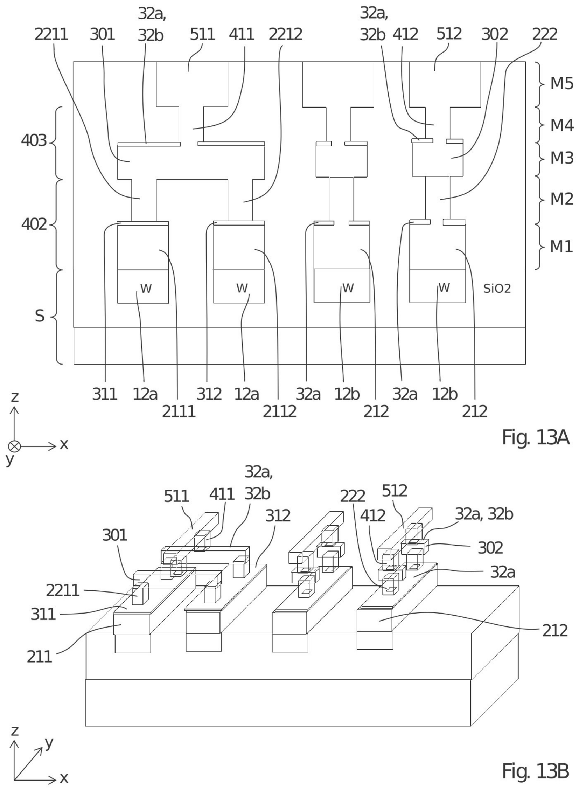

Les figures 13A, 13B illustrent un dispositif quantique obtenu par le procédé selon l'invention, comprenant des jonctions Josephson connectées en série deux à deux. Dans cet exemple, les jonctions Josephson sont intégrées entre les premier et deuxième niveaux M1, M2 de métal supraconducteur. Une première jonction Josephson est formée par une première ligne 2111, une première barrière 311 et un premier via 2211. Une deuxième jonction Josephson est formée par une deuxième ligne 2112, une deuxième barrière 312 et un deuxième via 2212. Les première et deuxième jonctions Josephson sont de préférence situées côte-à-côte. Les premier et deuxième vias 2211, 2212 sont ici reliés entre eux par une ligne supraconductrice 301 formée dans le troisième niveau de métal supraconducteur.

La ou les lignes supraconductrices 301 peuvent être formées comme précédemment, en utilisant une couche barrière structurée sous forme de motifs ouverts 32a, ou alternativement en utilisant une couche d'arrêt de gravure structurée sous forme de motifs ouverts 32b. Des vias 411 connectés aux lignes supraconductrices 301 au travers des ouvertures des motifs ouverts 32a, 32b, et des lignes 511 peuvent ensuite être formées, par exemple de façon classique par une technique connue de type « damascène » ou « double damascène ». Les niveaux M4, M5 de métal correspondant peuvent être supraconducteurs ou simplement métalliques.

Comme précédemment, des interconnexions peuvent être formées dans les niveaux M1, M2, M3, M4, M5 de métal, en même temps que les première et deuxième jonctions Josephson. Ces interconnexions comprennent typiquement une succession de vias et de lignes avec des motifs ouverts 32a, 32b intercalés. En particulier, une interconnexion surmontant un plot 12b comprend ici une ligne 212, un via 222 connecté à la ligne 212 au travers d'un motif ouvert 32a, un plot ou une ligne 302, un via 412 connecté à la ligne 302 au travers d'un motif ouvert 32a, 32b, une ligne 512.

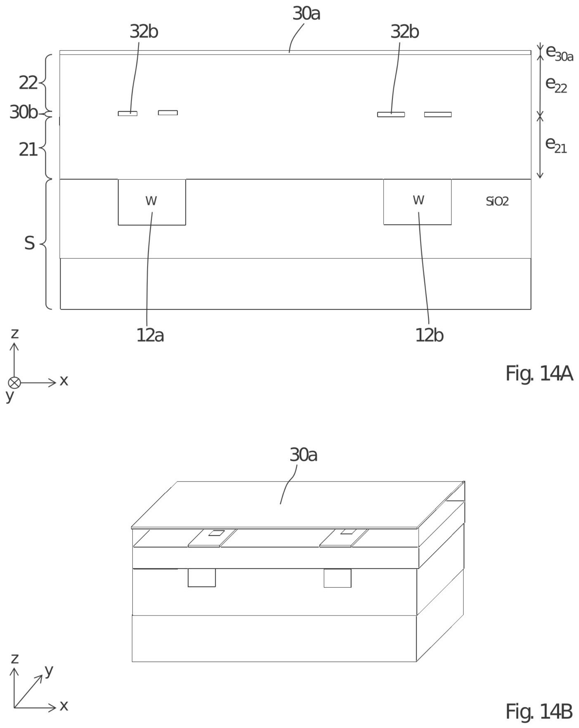

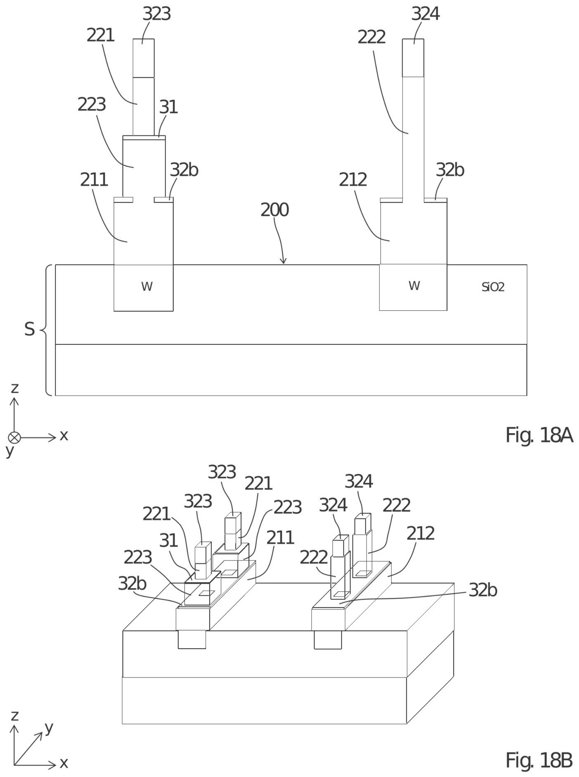

Les figures 14A, 14B à 18A, 18B illustrent des étapes de fabrication d'un dispositif comprenant une ou plusieurs jonctions Josephson (JJ) intégrées, selon un deuxième mode de réalisation de l'invention. Dans ce deuxième mode de réalisation, les jonctions Josephson du dispositif sont intégrées dans des niveaux d'interconnexions supérieurs. Seules les étapes et caractéristiques différentes du premier mode de réalisation sont détaillées ci-après, les autres étapes et caractéristiques étant réputées identiques à celles du premier mode de réalisation.

Comme illustré aux figures 14A, 14B, après formation de la première couche métallique supraconductrice 21, une couche d'arrêt de gravure 30b est formée sur la première couche métallique supraconductrice 21, puis structurée sous forme de motifs ouverts 32b uniquement, au-dessus des plots de connexion 12a, 12b. Cette couche d'arrêt de gravure est de préférence à base d'un matériau diélectrique pris parmi : SiO₂, TiO₂, HfO₂, MgO. Une deuxième couche métallique supraconductrice 22, est ensuite formée comme précédemment sur la première couche métallique supraconductrice 21, et sur les motifs ouverts 32b.

Une couche barrière 30a, différente ou distincte de la couche d'arrêt de gravure 30b, est ici formée sur la deuxième couche métallique supraconductrice 22. Comme précédemment, cette couche barrière 30a présente typiquement une épaisseur e₃₀ₐ de l'ordre de quelques nanomètres, par exemple entre 1 nm et 5 nm. Elle est de préférence à base d'un matériau pris parmi : SiO₂, AlOₓ, TiO₂, MgO.

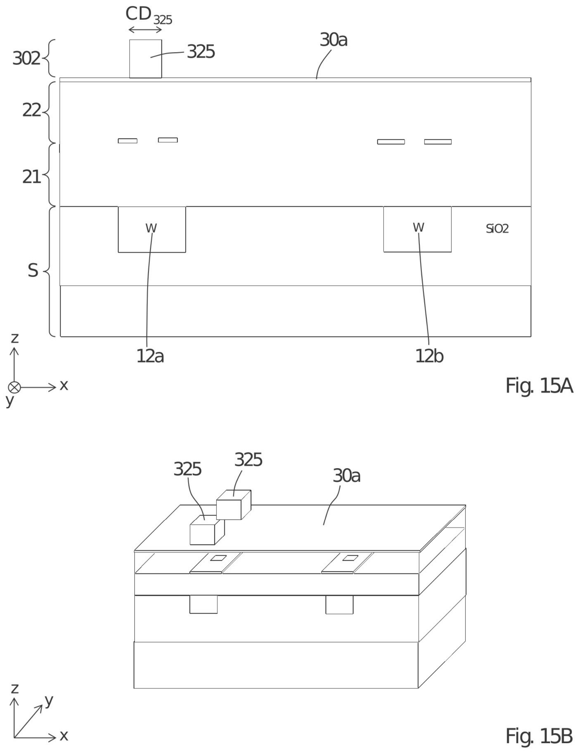

Comme illustré aux figures 15A, 15B, un deuxième masque de gravure 302 comprenant des motifs intermédiaires 325 est formé sur la couche barrière 30a. Ces motifs intermédiaires 325 sont alignés à l'aplomb des ouvertures de via 320 du motif ouvert 32b situé au-dessus du plot 12a, dans l'exemple illustré. Ces motifs intermédiaires 325 présentent typiquement une dimension CD₃₂₅ selon x supérieure, par exemple au moins 20% supérieure, à la dimension CDₒₚₑₙ selon x des ouvertures de via 320 du motif ouvert 32b. Cela facilite l'alignement des motifs 325, 32b entre eux. Le dimensionnement de la partie inférieure des jonctions de Josephson est également mieux contrôlé. La dimension CD₃₂₅ selon x des motifs intermédiaires 325 est par exemple comprise entre 10 nm et 200 nm.

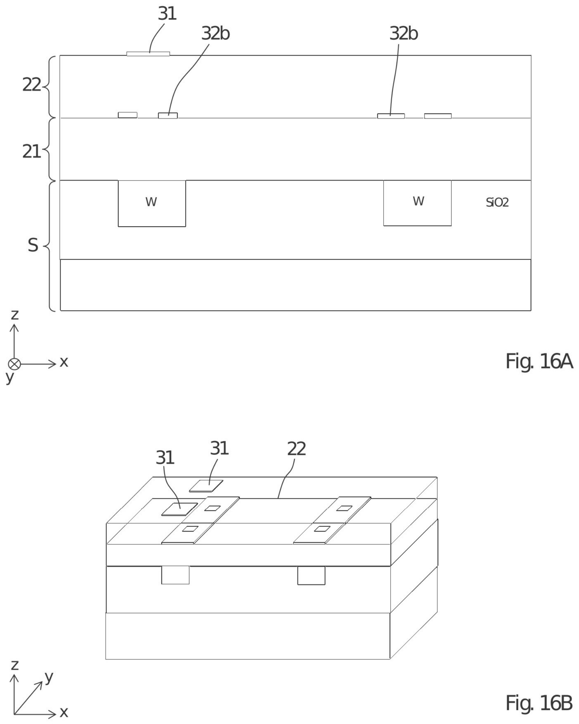

Comme illustré aux figures 16A, 16B, les motifs 325 sont transférés dans la couche barrière 30a par gravure anisotrope selon z de la couche barrière 30a en présence du masque 302. Les motifs 325 du masque 302 forment après gravure les motifs fermés 31 dans la couche barrière 30a. Le masque 302 est retiré après gravure, par exemple par plasma à base d'oxygène.

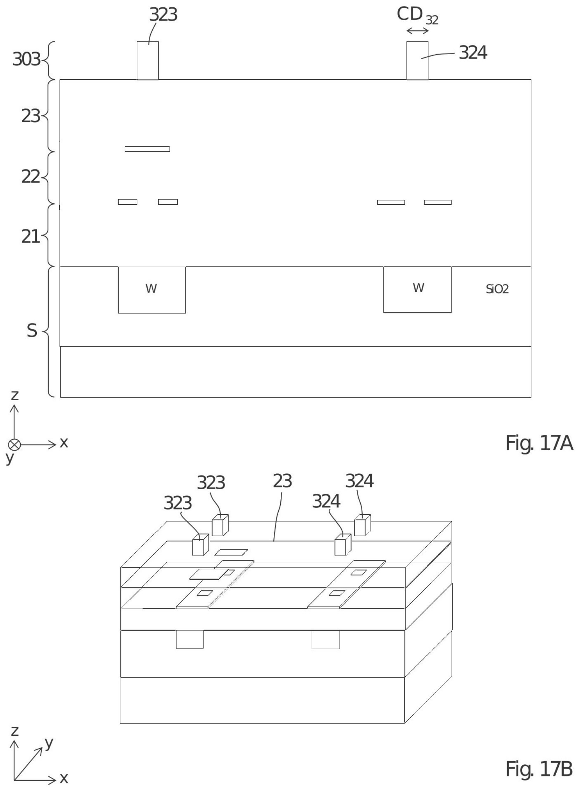

Comme illustré aux figures 17A, 17B, après structuration de la couche barrière 30a, une troisième couche métallique supraconductrice 23, typiquement à base d'un métal pris parmi ZrN, HfN, W, Nb, NbN, Ta, TaN, Ti, TiN, Al et leurs alliages, est ensuite formée sur la deuxième couche métallique supraconductrice 22, et sur les motifs fermés 31. La troisième couche métallique supraconductrice 23 correspond typiquement à un troisième niveau de métal supraconducteur.

Un troisième masque de gravure 303 comprenant des motifs de vias 323, 324 est formé sur la troisième couche métallique supraconductrice 23. Les motifs de vias 324 de ce troisième masque de gravure 303 sont alignés à l'aplomb des ouvertures de via 320 du motif ouvert 32b. Les motifs de via 323 de ce troisième masque de gravure 303 sont alignés à l'aplomb des motifs fermés 31. Les motifs de vias 324 présentent typiquement une dimension CD₃₂ selon x légèrement supérieure, par exemple 10% supérieure, à la dimension CDₒₚₑₙ selon x des ouvertures de via 320 du motif ouvert 32b. Cela facilite l'alignement des motifs 324, 32b entre eux. La dimension CD₃₂ selon x des motifs de vias 324 est ici par exemple comprise entre 10 nm et 150 nm.

Comme illustré aux figures 18A, 18B, les première, deuxième et troisième couches métalliques supraconductrices 21, 22, 23 sont ensuite gravées sur toute leur épaisseur, selon z, de part et d'autre des motifs de vias 323, 324 et de part et d'autre des motifs ouverts 32b et du motif fermé 31. Les troisième et deuxième couches métalliques supraconductrices 23, 22 sont d'abord gravées pour former les vias 222, 221 et le plot 223, puis la première couche métallique supraconductrice 21 est gravée pour former les lignes 212, 211. Les gravures des première, deuxième et troisième couches métalliques supraconductrices 21, 22, 23 sont de préférence enchaînées. Selon une possibilité, notamment lorsque les première, deuxième et troisième couches métalliques supraconductrices 21, 22, 23 sont de nature identique, les gravures de ces couches métalliques supraconductrices 21, 22, 23 sont effectuées en une seule et même étape, avec la même chimie de gravure.

Les gravures sont ici choisies de façon à graver sélectivement les métaux des première, deuxième et troisième couches métalliques supraconductrices 21, 22, 23 vis-à-vis du matériau de la couche barrière (structurée sous forme du motif 31) et vis-à-vis du matériau de la couche d'arrêt de gravure (structurée sous forme des motifs 32b). La couche d'arrêt de gravure et la couche barrière sont utilisées comme couches d'arrêt de gravure. En particulier, la sélectivité de gravure S_{22:31}, c'est-à-dire le rapport entre la vitesse de gravure du métal de la deuxième couche métallique supraconductrice 22 sur la vitesse de gravure du matériau de la couche barrière, est supérieure ou égale à 10:1, de préférence supérieure ou égale à 10:1. La sélectivité de gravure S_{21:31}, c'est-à-dire le rapport entre la vitesse de gravure du métal de la première couche métallique supraconductrice 21 sur la vitesse de gravure du matériau de la couche barrière, est supérieure ou égale à 10:1, de préférence supérieure ou égale à 10:1. La sélectivité de gravure S_{21:30b}, c'est-à-dire le rapport entre la vitesse de gravure du métal de la première couche métallique supraconductrice 21 sur la vitesse de gravure du matériau de la couche d'arrêt de gravure 30b, est supérieure ou égale à 10:1. Les gravures peuvent être à base d'une chimie chlorée. Alternativement, la ou les gravures du ou des matériaux supraconducteurs peuvent être effectuées en chimie fluorée ou fluoro-carbonée. Dans ce cas, il est préférable d'éviter SiN et SiO2 comme matériau diélectrique pour la couche barrière et pour la couche d'arrêt de gravure.

Un dispositif comprenant des interconnexions (212, 222) et des jonctions Josephson (211, 223, 31, 221) intégrées dans les niveaux d'interconnexions est ainsi avantageusement obtenu. Les jonctions Josephson comprennent ici une partie inférieure formée par la ligne 211 et le plot 223, une partie supérieure formée par le via 221, et une couche barrière 31 entre les parties inférieure et supérieure. Les jonctions Josephson sont ici intégrées entre les deuxième et troisième niveaux de métal.

L'invention n'est pas limitée aux modes de réalisations précédemment décrits. En particulier, il est envisageable de structurer la couche barrière et/ou la couche d'arrêt de gravure de façon indirecte, en formant des masques de gravure de polarité inverse puis en effectuant un dépôt localisé des matériaux de la couche barrière et/ou de la couche d'arrêt de gravure.

## Revendications

1. Procédé de fabrication d'une jonction Josephson comprenant :
- une fourniture d'un substrat (S) comprenant au moins un premier plot de connexion (12a) et un deuxième plot de connexion (12b),
- une formation d'au moins une première couche métallique supraconductrice (20a, 21, 22) sur des faces (120a, 120b) exposées des premier et deuxième plots de connexion (12a, 12b),
- une formation, sur l'au moins une première couche métallique supraconductrice (20a, 21, 22), d'au moins une couche d'arrêt de gravure (30, 30a, 30b),
- une structuration de l'au moins une couche d'arrêt de gravure (30, 30a, 30b), par l'intermédiaire d'au moins un premier masque (300a, 301, 302), de façon à exposer des parties de l'au moins une première couche métallique supraconductrice (20a, 21, 22) et à conserver des parties de l'au moins une couche d'arrêt de gravure (30, 30a, 30b) sous forme d'au moins un motif fermé (31) surmontant le premier plot de connexion (12a) et au moins un motif ouvert (32a, 32b) surmontant le deuxième plot de connexion (12b), ledit au moins un motif ouvert (32a, 32b) comprenant au moins une ouverture de via (320) débouchant sur l'au moins une première couche métallique supraconductrice (20a, 21, 22) sous-jacente,
- une formation d'au moins une deuxième couche métallique supraconductrice (20b, 22, 23) sur les parties exposées de l'au moins une première couche métallique supraconductrice (20a, 21, 22) et sur l'au moins un motif fermé (31) et l'au moins un motif ouvert (32a, 32b),
- une formation, sur l'au moins une deuxième couche métallique supraconductrice (20b, 22, 23), d'au moins un deuxième masque (300b, 302, 303) définissant au moins un niveau de vias à l'aplomb de l'au moins un motif fermé (31) et à l'aplomb de l'au moins une ouverture de via (320) de l'au moins un motif ouvert (32a, 32b),
- une gravure de l'au moins une deuxième couche métallique supraconductrice (20b, 22, 23), ladite gravure étant configurée pour former les vias (221, 222, 223) de l'au moins un niveau de vias en s'arrêtant sur les motifs (31, 32a, 32b) de l'au moins une couche d'arrêt de gravure (30, 30a, 30b) et,
- une gravure de l'au moins une première couche métallique supraconductrice (20a, 21, 22) de part et d'autre de l'au moins un motif fermé (31) et de l'au moins un motif ouvert (32a, 32b), ladite gravure étant configurée pour former des lignes (211, 212) de niveau inférieur en s'arrêtant sur le substrat (S),
ledit procédé étant **caractérisé en ce que** l'au moins un motif fermé (31) de l'au moins une couche d'arrêt de gravure (30, 30a, 30b) comprend une couche barrière (30a) à base d'un matériau de jonction Josephson présentant, vis-à-vis de l'au moins une première couche métallique supraconductrice (20a, 21, 22), une sélectivité S_{20a:30a} à la gravure supérieure ou égale à 10:1, de sorte que l'au moins un motif ouvert (32a, 32b) forme, en empilement avec un premier via (221) de l'au moins un niveau de vias et une première ligne (211) de niveau inférieur, une interconnexion (222, 212), et de sorte que l'au moins un motif fermé (31) forme, en empilement avec un deuxième via (221) de l'au moins un niveau de vias et une deuxième ligne (211) de niveau inférieur, la jonction Josephson.

2. Procédé selon la revendication précédente, dans lequel le ou les vias (221) de l'au moins un niveau de vias surmontant l'au moins un motif fermé (31) présentent une dimension critique CDᵥᵢₐ₂₂₁, prise selon un axe x, inférieure à une dimension CD₁, prise selon l'axe x, de l'au moins un motif fermé (31).

3. Procédé selon l'une quelconque des revendications précédentes, dans lequel le ou les vias (222) de l'au moins un niveau de vias surmontant l'au moins un motif ouvert (32a, 32b) présentent une dimension critique CDᵥᵢₐ₂₂₂, prise selon un axe x, supérieure ou égale à une dimension CDₒₚₑₙ de l'au moins une ouverture de via (320) prise selon l'axe x.

4. Procédé selon l'une quelconque des revendications précédentes, dans lequel la gravure de l'au moins une deuxième couche métallique supraconductrice (20b, 22, 23) et la gravure de l'au moins une première couche métallique supraconductrice (20a, 21, 22) sont réalisées par une seule et même gravure, lors d'une seule et même étape.

5. Procédé selon l'une quelconque des revendications précédentes dans lequel l'au moins un motif fermé (31) comprend un premier motif fermé (311) et un deuxième motif fermé (312), lesdits premier et deuxième motifs fermés (311, 312) étant surmontés respectivement par des troisième et quatrième vias (2211, 2212), ledit procédé comprenant en outre, après formation de l'ensemble des vias (2211, 2212, 222) de l'au moins un niveau de vias et de l'ensemble des lignes (211, 212) de niveau inférieur, une formation d'au moins une ligne métallique supraconductrice (301) de niveau supérieur reliant les troisième et quatrième vias (2211, 2212), de façon à former un dispositif comprenant plusieurs jonctions Josephson.

6. Procédé de fabrication d'une jonction Josephson selon l'une quelconque des revendications précédentes comprenant les étapes suivantes :
- une fourniture d'un substrat (S) comprenant au moins un premier plot de connexion (12a) et un deuxième plot de connexion (12b),
- une formation d'une première couche métallique supraconductrice (21) sur des faces (120a, 120b) exposées des premier et deuxième plots de connexion (12a, 12b),
- une formation, sur la première couche métallique supraconductrice (21), d'une couche barrière (30a) à base d'un matériau de jonction Josephson présentant, vis-à-vis de la première couche métallique supraconductrice (21), une sélectivité S_{21:30a} à la gravure supérieure ou égale à 10:1,
- une structuration de la couche barrière (30a), par l'intermédiaire d'au moins un premier masque (301), de façon à exposer des parties de la première couche métallique supraconductrice (21) et à conserver des parties de la couche barrière (30a) sous forme d'au moins un motif fermé (31) surmontant le premier plot de connexion (12a) et au moins un motif ouvert (32a) surmontant le deuxième plot de connexion (12b), ledit au moins un motif ouvert (32a) comprenant au moins une ouverture de via (320) débouchant sur la première couche métallique supraconductrice (21) sous-jacente,
- une formation d'une deuxième couche métallique supraconductrice (22) sur les parties exposées de la première couche métallique supraconductrice (21) et sur l'au moins un motif fermé (31) et l'au moins un motif ouvert (32a),
- une formation, sur la deuxième couche métallique supraconductrice (22), d'un deuxième masque (302) définissant un deuxième niveau de vias à l'aplomb de l'au moins un motif fermé (31) et à l'aplomb de l'au moins une ouverture de via (320) de l'au moins un motif ouvert (32a),
- une gravure de la deuxième couche métallique supraconductrice (22), ladite gravure étant configurée pour former les vias (221, 222) du deuxième niveau en s'arrêtant sur la couche barrière (30a) et,
- une gravure de la première couche métallique supraconductrice (21) de part et d'autre de l'au moins un motif fermé (31) et de l'au moins un motif ouvert (32a), ladite gravure étant configurée pour former des lignes (211, 212) de premier niveau en s'arrêtant sur le substrat (S).

7. Procédé de fabrication d'une jonction Josephson selon l'une quelconque des revendications 1 à 8 comprenant les étapes suivantes :
- une fourniture d'un substrat (S) comprenant au moins un premier plot de connexion (12a) et un deuxième plot de connexion (12b),
- une formation d'une première couche métallique supraconductrice (21) sur des faces (120a, 120b) exposées des premier et deuxième plots de connexion (12a, 12b),
- une formation, sur la première couche métallique supraconductrice (21), d'une couche d'arrêt de gravure (30b),
- une structuration de la couche d'arrêt de gravure (30b), par l'intermédiaire d'au moins un premier masque (301), de façon à exposer des parties de la première couche métallique supraconductrice (21) et à conserver des parties de la couche d'arrêt de gravure (30b) sous forme d'au moins un motif ouvert (32b) surmontant les premier et deuxième plots de connexion (12a, 12b), ledit au moins un motif ouvert (32b) comprenant au moins une ouverture de via (320) débouchant sur la première couche métallique supraconductrice (21) sous-jacente,
- une formation d'une deuxième couche métallique supraconductrice (22) sur les parties exposées de la première couche métallique supraconductrice (21) et sur l'au moins un motif ouvert (32b),
- une formation, sur la deuxième couche métallique supraconductrice (22), d'une couche barrière (30a) à base d'un matériau de jonction Josephson présentant, vis-à-vis de la deuxième couche métallique supraconductrice (22), une sélectivité S_{22:30a} à la gravure supérieure ou égale à 10:1,
- une structuration de la couche barrière (30a), par l'intermédiaire d'au moins un deuxième masque (302), de façon à exposer des parties de la deuxième couche métallique supraconductrice (22) et à conserver des parties de la couche barrière (30a) sous forme d'au moins un motif fermé (31) surmontant le premier plot de connexion (12a),
- une formation d'une troisième couche métallique supraconductrice (23) sur les parties exposées de la deuxième couche métallique supraconductrice (22) et sur l'au moins un motif fermé (31),
- une formation, sur la troisième couche métallique supraconductrice (23), d'un troisième masque (303) définissant des vias à l'aplomb de l'au moins un motif fermé (31) et à l'aplomb de l'au moins une ouverture de via (320) de l'au moins un motif ouvert (32b),
- au moins une gravure des troisième, deuxième et première couches métalliques supraconductrices (23, 22, 21), ladite au moins une gravure étant configurée pour former les vias (221, 222, 223) en s'arrêtant sur la couche barrière (30a) et sur la couche d'arrêt de gravure (30b), et pour former des lignes (211, 212) de premier niveau en s'arrêtant sur le substrat (S).

8. Procédé selon la revendication précédente, dans lequel l'au moins un motif fermé (31) présente une dimension CD₁, prise selon un axe x, inférieure à une dimension CD₂, prise selon l'axe x, de l'au moins un motif ouvert (32b) sous-jacent.

9. Dispositif quantique comprenant en empilement suivant une direction z :
- un substrat (S) comprenant au moins un premier plot de connexion (12a) et un deuxième plot de connexion (12b),
- une interconnexion (222, 212) connectant le deuxième plot de connexion (12b), comprenant :
∘ au moins une première ligne métallique supraconductrice (212) à base d'un premier métal supraconducteur, et,
∘ au moins un premier via métallique (222) à base d'un deuxième métal supraconducteur, connecté à ladite au moins une ligne métallique (212),
∘ une couche première barrière (32a) intercalée entre l'au moins un premier via (222) et l'au moins une première ligne (212), ladite première couche barrière (32a) comprenant au moins une ouverture de via (320) de sorte que l'au moins un premier via (222) et l'au moins une première ligne (212) sont connectés au travers de ladite au moins une ouverture de via (320),
- une jonction de Josephson connectant le premier plot de connexion (12a), comprenant :
∘ au moins une deuxième ligne métallique (211) à base du premier métal supraconducteur, et,
∘ au moins un deuxième via métallique (221) à base du deuxième métal supraconducteur,
∘ une deuxième couche barrière (31) intercalée entre l'au moins un deuxième via (221) et l'au moins une deuxième ligne (211), ladite deuxième couche barrière (31) séparant l'au moins un deuxième via (221) et l'au moins une deuxième ligne (211).

10. Dispositif selon la revendication précédente, dans lequel l'au moins un premier via métallique (222) de l'interconnexion (222, 212) connectant le deuxième plot de connexion (12b) présente une dimension critique CDᵥᵢₐ₂₂₂, prise selon un axe x, supérieure ou égale à une dimension CDₒₚₑₙ de l'au moins une ouverture de via (320) prise selon l'axe x.

11. Dispositif selon l'une quelconque des revendications 9 à 10, dans lequel l'au moins un deuxième via métallique (221) de la jonction de Josephson présente une dimension critique CDᵥᵢₐ₂₂₁, prise selon un axe x, strictement inférieure à une dimension CD₃₁, prise selon l'axe x, de la couche barrière (31) séparant l'au moins un via (221) et l'au moins une ligne (211) de la jonction de Josephson.

12. Dispositif selon l'une quelconque des revendications 9 à 11, dans lequel les premier et deuxième métaux sont à base du même métal pris parmi ZrN, HfN, W, Nb, NbN, Ta, TaN, Ti, TiN, Al et leurs alliages.

13. Dispositif selon l'une quelconque des revendications 9 à 12, dans lequel les première et deuxième couches barrières (31, 32a) présentent une sélectivité à la gravure S_{21:32a} ou S_{21:31} supérieure ou égale à 10:1 vis-à-vis du premier métal supraconducteur.

14. Dispositif selon l'une quelconque des revendications 9 à 13, dans lequel la deuxième couche barrière (31) intercalée entre l'au moins un deuxième via (221) et l'au moins une deuxième ligne (211) de la jonction de Josephson est continue et ne comprend pas d'ouverture de via.

15. Dispositif selon l'une quelconque des revendications 9 à 14, dans lequel les première et deuxième couches barrières (31, 32a) sont distinctes et séparées l'une de l'autre.
